# EUROPÄISCHE PATENTANMELDUNG

(11) **EP 2 451 078 A1**
(43) Veröffentlichungstag der Anmeldung: **09.05.2012**
(21) Anmeldenummer: 11186959.0
(22) Anmeldetag: 27.10.2011
(51) Int. Cl.: H03K 17/00, H03K 17/96

(54) **Bedieneinrichtung für ein Elektrogerät und Verfahren zur Herstellung einer solchen Bedieneinrichtung**

(30) Priorität: 03.11.2010 DE 102010043299
(71) Anmelder: E.G.O. Elektro-Gerätebau GmbH, 75038 Oberderdingen (DE)
(72) Erfinder: Fluhrer, Henry, 75015 Bretten (DE)
(74) Vertreter: Patentanwälte Ruff, Wilhelm, Beier, Dauster & Partner

(57) **Zusammenfassung**

Eine Bedieneinrichtung für ein Elektrogerät weist ein formveränderliches Bedien-Feld auf, in welches eine Bedien-Kraft eingeleitet wird zur Durchbiegung und zur Bedienung. Hinter dem Bedien-Feld ist mindestens ein Piezo-Sensorelement angeordnet mit mechanischer Kopplung an das Bedien-Feld, wobei das Piezo-Sensorelement von einer piezoaktiven PZT-Schicht mit geringer Dicke gebildet ist, welche auf einen Träger aufgebracht ist und mit der Vorderseite zu dem Bedien-Feld hin weist. Auf der freien Rückseite des Piezo-Sensorelementes ist eine Elektrodenstruktur mit Elektroden aufgebracht mit einer elektrischen Kontaktierung an einen Leiterbahnträger zum elektrischen Anschluss.

## Beschreibung

### Anwendungsgebiet und Stand der Technik

Die Erfindung betrifft eine Bedieneinrichtung für ein Elektrogerät mit einem formveränderlichen bzw. elastischen Bedien-Feld. Durch Auflegen eines Fingers an einen Bedienort wird eine Bedien-Kraft in das Bedien-Feld eingeleitet und biegt es etwas durch, was erfasst und als Bedienung ausgewertet werden kann. Des Weiteren betrifft die Erfindung ein Verfahren zur Herstellung einer solchen Bedieneinrichtung.

Aus der EP 2 144 372 A1 ist eine Bedieneinrichtung dieser Art bekannt. Dabei werden Piezo-Sensorelemente als Sensoren verwendet, um die Durchbiegung zu erfassen. Die Piezo-Sensorelemente werden dabei als scheibenförmige Bauteile verwendet.

### Aufgabe und Lösung

Der Erfindung liegt die Aufgabe zugrunde, eine eingangs genannte Bedieneinrichtung sowie ein entsprechendes Verfahren zur Herstellung einer solchen Bedieneinrichtung zu schaffen, mit der Probleme des Standes der Technik beseitigt werden können und insbesondere eine vorteilhaft herstellbare Bedieneinrichtung geschaffen werden kann, welche mit wenig Aufwand großserientechnisch hergestellt werden kann.

Gelöst wird diese Aufgabe durch eine Bedieneinrichtung mit den Merkmalen des Anspruchs 1 sowie ein Verfahren zur Herstellung einer solchen Bedieneinrichtung mit den Merkmalen des Anspruchs 15. Vorteilhafte sowie bevorzugte Ausgestaltungen der Erfindung sind Gegenstand der weiteren Ansprüche und werden im Folgenden näher erläutert. Dabei werden manche der nachfolgend genannten Merkmale nur für die Bedieneinrichtung oder nur für das Verfahren beschrieben. Sie sollen jedoch unabhängig davon sowohl für die Bedieneinrichtung als auch für das Verfahren gelten können. Der Wortlaut der Ansprüche wird durch ausdrückliche Bezugnahme zum Inhalt der Beschreibung gemacht.

Es ist vorgesehen, dass hinter dem Bedien-Feld der Bedieneinrichtung mindestens ein Piezo-Sensorelement angeordnet ist, welches mechanisch an das Bedien-Feld gekoppelt ist bzw. damit verbunden ist. Das Bedien-Feld kann dabei insbesondere ein Rahmen oder eine Bedienblende des Elektrogerätes sein. Die Formveränderlichkeit bzw. Elastizität ist relativ gering und in der Praxis kann die resultierende Durchbiegung bei Auflegen eines Fingers nur 5 µm bis 100 µm oder sogar mehrere 100 µm betragen.

Erfindungsgemäß ist das Piezo-Sensorelement von einer piezoaktiven PZT-Schicht gebildet, die vorteilhaft geringe Dicke aufweist. Diese geringe Dicke kann besonders vorteilhaft im Bereich von 1 µm bis 10 µm liegen. Das Piezo-Sensorelement bzw. die PZT-Schicht ist auf einen elektrisch leitfähigen Träger aufgebracht und weist dabei mit seiner Vorderseite zu dem Bedien-Feld hin bzw. zu einem späteren Bedienort durch einen Bediener. Auf der freien Rückseite des Piezo-Sensorelementes ist eine Elektrodenstruktur vorgesehen bzw. es sind Elektroden aufgebracht, die die Elektrodenstruktur bilden. Diese Elektroden können eine elektrische Kontaktierung an einen Leiterbahnträger odgl. aufweisen zum elektrischen Anschluss, also um das mindestens eine Piezo-Sensorelement ansteuern und auswerten zu können.

Somit ist es mit der Erfindung möglich, eine Bedieneinrichtung zu schaffen, bei der das Piezo-Sensorelement hergestellt ist gemäß dem Verfahren zur Aufbringung von PZT-Schichten, wie es aus der DE 19744630 C1 bekannt ist, deren Inhalt diesbezüglich durch ausdrückliche Bezugnahme zum Inhalt der vorliegenden Beschreibung gemacht wird, um auf das separate Herstellen von einzelnen Piezo-Scheiben und deren einzelnes Aufkleben zu verzichten. Durch das Beschichtungsverfahren der PZT-Schicht können im Wesentlichen frei oder beliebig gestaltete und auch im Wesentlichen beliebig große Flächen homogen und mit möglichst gleichbleibender Dicke auf einen Träger aufgebracht werden. Des Weiteren können diese Schichten, wie die vorgenannten geringen Dicken zeigen, erheblich dünner sein als bislang verwendete, separat hergestellte und dann beispielsweise aufgeklebte Piezo-Scheiben.

Der Träger kann vorteilhaft aus Metall bestehen, insbesondere aus Edelstahl, sodass die elektrische Leitfähigkeit gegeben ist. Besonders vorteilhaft kann der Träger ein Blech sein.

In Ausgestaltung der Erfindung bildet die Elektrodenstruktur mit Elektroden eine elektrische Kontaktierung der Sensorelemente an einen Leiterbahnträger zum elektrischen Anschluss.

Vorteilhaft bedeckt die Elektrodenstruktur eine Teilfläche der PZT-Schicht zur Bildung der Sensorelemente aus der Teilfläche der Elektrodenstruktur, der sich in Deckung mit dieser Teilfläche befindlichen PZT-Schicht und dem elektrisch leitfähigen Träger. So können quasi aus einer zusammenhängenden PZT-Schicht mehrere Sensorelemente gebildet werden, die sich nicht gegenseitig beeinflussen, sondern getrennt ausgewertet werden können.

In Ausgestaltung der Erfindung kann das Piezo-Sensorelement flächig sein, insbesondere also eine gewisse Ausdehnung aufweisen, beispielsweise von mehreren Quadratzentimetern. Das Piezo-Sensorelement ist mit dem Bedien-Feld verbunden bzw. daran befestigt. Vorteilhaft kann dies direkt an dessen Rückseite erfolgen, so dass der genannte Träger mit seiner Vorderseite das Bedien-Feld bildet, was nachfolgend noch näher ausgeführt wird.

In weiterer möglicher Ausgestaltung der Erfindung kann der genannte Leiterbahnträger eine Folienleiterplatte sein. Dies ermöglicht eine geringe Dicke sowie eine flexible und einfache Weiterführung der Leiterbahnen als elektrische Verbindung beispielsweise an eine Steuerung bzw. einen entsprechenden Chip. Alternativ dazu kann der Leiterbahnträger eine übliche Leiterplatte sein. Vorteilhaft sind allgemein die Leiterbahnen auf dem Leiterbahnträger zu dem Piezo-Sensorelement hin zugewandt.

In Ausgestaltung der Erfindung können an dem Leiterbahnträger elektrische Bauteile vorgesehen sein, beispielsweise SMD-Bauteile in Form von Beschaltungsteilen oder auch eines vorgenannten Chips, insbesondere als Microcontroller bzw. IC. Diese Bauteile sind besonders vorteilhaft an der von dem Piezo-Sensorelement abgewandten Seite des Leiterbahnträgers vorgesehen, so dass sie eine mechanische und elektrische Anbindung zwischen Piezo-Sensorelement und Leiterbahnträger nicht behindern. So kann der Abstand sehr gering sein. Dadurch, dass an dem Leiterbahnträger weitere Bauteile vorgesehen sein können, kann eine sehr hohe Integration der Bedieneinrichtung geschaffen werden. Des Weiteren können Signalwege sehr kurz gehalten werden, was die Störanfälligkeit verringert. Gemäß einer weiteren Ausgestaltung können elektrische Bauteile auch direkt auf das Piezo-Sensorelement bzw. die PZT Schicht, insbesondere auf Kontaktierflächen der PZT Schicht, aufgebracht bzw. mit diesen verbunden werden.

In einer Ausgestaltung der Erfindung kann der Träger für das Piezo-Sensorelement an der Rückseite einer Bedienblende befestigt sein und dabei vorteilhaft als dünne Platte ausgebildet sein. Es ist hier also sowohl er Träger als auch die Bedienblende vorgesehen, beispielsweise als Platte aus Kunststoff oder Metall mit einer Dicke von wenigen mm bis zu unter 1 mm. An der Rückseite der Bedienblende ist dann eben der plattenartige Träger vorgesehen, an dessen Rückseite das Piezo-Sensorelement aufgebracht ist. Bedienblende und Träger können beispielsweise durch eine Klebeschicht oder eine sonstige enge und im Wesentlichen unlösbare Verbindung miteinander verbunden sein, wobei sich auch ein Einspritzen eignet. Dadurch ist es möglich, dass vor allem bei sehr großen, unhandlichen oder empfindlichen Bedienblenden das Piezo-Sensorelement separat auf den Träger aufgebracht wird in einem speziellen Verfahren, üblicherweise einem Vakuumverfahren, welches sich für solche großen Bedienblenden nicht eignet. Anschließend werden die vorkonfektionierten Träger mit Piezo-Sensorelementen sowie dem weitergehenden Aufbau mit Elektrodenstruktur und Leiterbahnträger an der Bedienblende befestigt bzw. angeklebt. So kann insbesondere das Aufbringen der Piezo-Sensorelemente auf den Träger optimal erfolgen.

In alternativer Ausgestaltung der Erfindung kann das Piezo-Sensorelement direkt auf die Rückseite einer Bedienblende aufgebracht werden, die dann als eingangs genannter Träger fungiert bzw. diesen auch bildet. Somit ist die Bedienblende also sowohl Bedienblende als auch Träger für das Sensorelement in einem einzigen Teil. Hier ist mit großer Wahrscheinlichkeit der Aufwand für das Aufbringen des Piezo-Sensorelementes größer, da ein vorgenannter separater Träger eben nur unwesentlich größer sein muss als das Piezo-Sensorelement selbst. Eine entsprechende Bedienblende wird üblicherweise deutlich größer sein. Der Vorteil, das Piezo-Sensorelement direkt auf die Rückseite der Bedienblende aufzubringen, liegt jedoch darin, dass zum einen ein nachfolgender Befestigungsschritt wie zuvor beschrieben entfällt sowie damit verbundene mögliche Fehlerquellen. Des Weiteren ist die Kraftübertragung durch einen auf die Vorderseite der Bedienblende aufgelegten Finger an dem Bedienort in das Piezo-Sensorelement hinein noch direkter und somit noch genauer auswertbar.

Des Weiteren müssen auch noch die Elektroden auf die Rückseite des Piezo-Sensorelementes aufgebracht werden, was dann eben die genannte Elektrodenstruktur ergibt. Dies ist aber üblicherweise mit einfacheren Verfahren möglich als für das Piezo-Sensorelement mit der PZT-Schicht selbst.

Als elektrische Kontaktierung an den Leiterbahnträger können einerseits ein Leitkleber und andererseits elektrisch leitfähige, elastische Kontaktelemente vorgesehen sein. Solche Kontaktelemente können entweder metallische bzw. elektrisch leitfähige Federn sein, insbesondere Schraubenfedern. Alternativ können es Kunststoffelemente aus elektrisch leitfähigem, elastischem Kunststoff sein. Die Kontaktelemente können zur sicheren und dauerhaften elektrischen Kontaktierung an den Elektroden oder an dem Leiterbahnträger, unter Umständen auch an beiden, festgeklebt sein mit Leitkleber.

In vorteilhafter Ausgestaltung der Erfindung ist die PZT-Schicht als Piezo-Sensorelement großflächig aufgebracht und ausgebildet. Vorteilhaft bildet sie dabei das einzige Piezo-Sensorelement der Bedieneinrichtung bzw. ist die einzige PZT-Schicht. Für eine Unterteilung in mehrere sozusagen getrennt voneinander funktionierende Sensorelemente zur Erfassung mehrerer unterschiedlicher Bedienorte können die Elektroden auf der Rückseite der PZT-Schicht unterschiedlich groß und/oder unterschiedlich geformt und angeordnet sein. Somit braucht also die PZT-Schicht nicht strukturiert oder unterbrochen zu werden. Es reicht, wenn durch separate Elektroden an zumindest einer Seite des Piezo-Sensorelementes eine in deren Bereich auftretende Verformung erkannt wird. Bei gleichzeitiger Auswertung mehrerer einzelner Sensorelemente bei mehreren Elektroden wird, wie allgemein bekannt, derjenige Bedienort als vorliegend an derjenigen Stelle ermittelt, an der sich das stärkste elektrische Signal ergibt.

In vorteilhafter Weiterbildung der Erfindung weist die PZT-Schicht für das Piezo-Sensorelement eine rechteckige Form auf, die insbesondere langgestreckt ist, beispielsweise bis zu doppelt so lang ist wie breit. In zwei gegenüberliegenden Randbereichen, insbesondere an den Längsseiten, können längliche Neutralelektroden auf der Rückseite des Piezo-Sensorelementes aufgebracht sein. Diese Neutralelektroden erstrecken sich vorteilhaft in einer Richtung über den wesentlichen Teil der Länge des Piezo-Sensorelementes. Sie dienen dazu, den Bedienort in Relation zum Abstand zur einen Neutralelektrode oder zur anderen Neutralelektrode zu bestimmen. Somit kann also ermittelt werden, ob ein Bedienort näher zur einen oder näher zur anderen Seite vorliegt. Dies wird insbesondere anhand der Ausführungsbeispiele noch klarer, weil dadurch noch mehr unterschiedliche Bedienorte erfasst bzw. voneinander unterschieden werden können.

In vorteilhafter Weiterbildung der Erfindung können weitere Elektroden zwischen den genannten Neutralelektroden ausschließlich so vorgesehen sein, dass sie in der Längsrichtung der Neutralelektroden nebeneinander angeordnet sind und sich dabei nicht überlappen. Dies bedeutet also, dass sich zwischen zwei Neutralelektroden auf deren kürzestem Abstand jeweils nur eine einzige weitere Elektrode befindet. Somit ist es also für die Bestimmung eines Bedienortes entlang der Längsrichtung der Neutralelektroden bzw. des Piezo-Sensorelementes möglich, diese verschiedenen Elektroden auszuwerten, also in welchem Längsbereich des Piezo-Sensorelementes ein Bedienort liegt. In Querrichtung dazu kann der Bedienort durch Vergleich der Signale an den beiden Neutralelektroden ermittelt werden, ob also ein Bedienort näher zu der einen oder näher zu der anderen hin liegt bzw. mit jeweils welchem Abstand dazu.

Die genannte Elektrodenstruktur bildet also die Rückseitenkontaktierung an das Piezo-Sensorelement, die durch ihre unterschiedliche Flächenaufteilung quasi unterschiedliche und mehrere Sensorelemente bildet. Eine Vorderseitenkontaktierung an das Piezo-Sensorelement bzw. die PZT-Schicht kann einheitlich erfolgten und somit an einer einzigen Fläche. Eine Vorderseitenelektrode kann entweder von dem Träger gebildet werden, auf den die PZT-Schicht aufgebracht ist, was leicht möglich ist, wenn dieser metallisch ist und somit elektrisch leitfähig ist. Dann braucht der Träger nur noch eine elektrische Kontaktierung an den Leiterbahnträger, was beispielsweise über die vorgenannten elastischen bzw. federnden Kontaktelemente möglich ist. Alternativ kann auf einen Träger aus einem isolierenden Material eine elektrisch leitfähige Schicht aufgebracht werden, auf welche dann die PZT-Schicht aufgebracht wird. Dabei spielt es keine Rolle, ob ein separater Träger vorgesehen ist oder die PZT-Schicht direkt auf die Rückseite der Bedienblende als Träger aufgebracht wird.

In weiterer Ausgestaltung der Erfindung ist es möglich, dass von den Elektroden leitfähige Abschnitte bzw. Leiterbahnen abgehen, an deren Ende ein Kontaktierfeld vorgesehen ist. Dies ist insbesondere dann von Vorteil, wenn Auswertung und Steuerung für das Piezo-Sensorelement nicht an dem Leiterbahnträger selbst vorgesehen sind, sondern an einer separaten Steuerung. Diese Lösung eignet sich also insbesondere auch für einen Leiterbahnträger in Form einer Folienleiterplatte.

Vorteilhaft enden die Kontaktierfelder sämtlicher Elektroden, also auch der Vorderseitenelektrode, in einem gemeinsamen Kontaktierbereich am Leiterbahnträger. Sie liegen dort zwar getrennt voneinander, räumlich aber eng beieinander vor. So kann beispielsweise leicht eine Steckverbindung an eine sonstige Steuerung, beispielsweise eine allgemeine Steuerung des Elektrogerätes, erreicht werden.

Bei einem erfindungsgemäßen Verfahren zur Herstellung einer vorbeschriebenen Bedieneinrichtung können nach den vorbeschriebenen Verfahrensschritten zum Aufbringen der PZT-Schicht auf einen separaten Träger oder die Rückseite einer Bedienblende noch die Schritte zur Polarisierung der PZT-Schicht vorgesehen sein. Dazu wird eine Maske, die vorteilhaft eine Metallfolie sein kann, auf die Rückseite der PZT-Schicht aufgebracht. Dabei werden die genannten Elektroden ausgespart. Nach der üblichen Polarisierung der PZT-Schicht, die wie in der eingangs genannten DE 19744630 C1 beschrieben erfolgen kann, wird die Maske wieder entfernt und die PZT-Schicht kann als Piezo-Sensorelement arbeiten bzw. verwendet werden. Dabei können Flächenanteile, die mit Leiterbahnen oder Bauteilen versehen werden, bedeckt werden und nicht polarisiert werden, insbesondere eben mit der Maske.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: einen Schnitt durch eine erfindungsgemäße Bedieneinrichtung in einer ersten Ausgestaltung,
- Fig. 2: eine Draufsicht von hinten auf ein Piezo-Sensorelement der Bedieneinrichtung aus Fig. 1 mit Elektrodenstruktur,
- Fig. 3: eine Draufsicht auf eine Leiterplatte zur elektrischen Kontaktierung an die Elektrodenstruktur aus Fig. 1,
- Fig. 4: einen Schnitt ähnlich Fig. 1 durch eine alternative Ausgestaltung einer Bedieneinrichtung in einer zweiten Variante,
- Fig. 5: eine Draufsicht auf eine Folienleiterplatte aus Fig. 4 zur elektrischen Kontaktierung,
- Fig. 6: einen Schnitt durch eine dritte Variante einer Bedieneinrichtung ähnlich Fig. 1,
- Fig. 7: eine Draufsicht entsprechend Fig. 2 auf die Bedieneinrichtung aus Fig. 6 und
- Fig. 8: eine weitere alternative Ausgestaltung einer Bedieneinrichtung mit einer vierten Variante einer Elektrodenstruktur in einer Darstellung ähnlich Fig. 2.

### Detaillierte Beschreibung der Ausführungsbeispiele

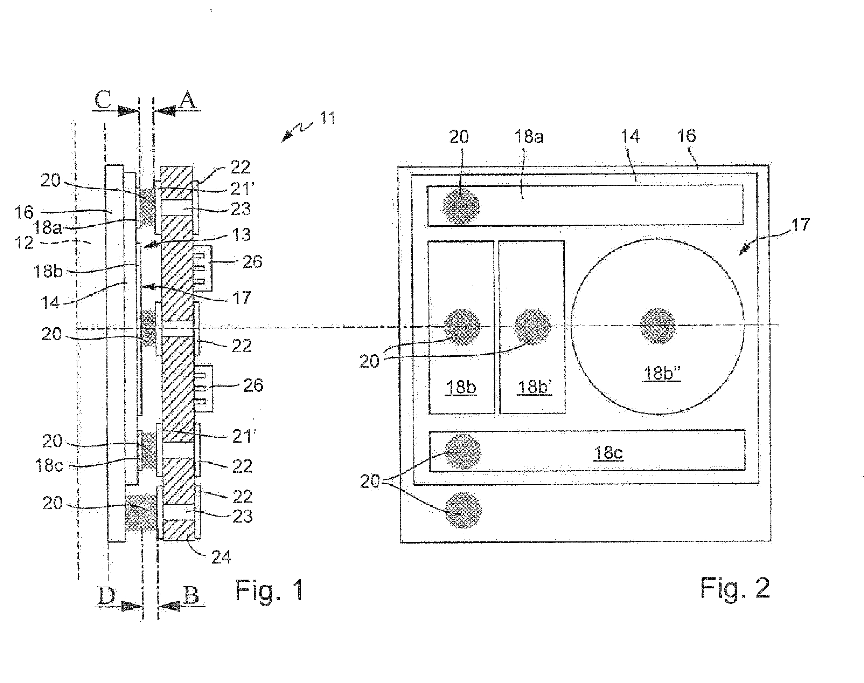

In Fig. 1 ist in Schnittdarstellung eine erfindungsgemäße Bedieneinrichtung 11 dargestellt. Hinter einer gestrichelt dargestellten Bedienblende 12 befindet sich ein Piezo-Sensorelement 13, welches im Wesentlichen von einer PZT-Schicht 14 gebildet ist, die auf die Rückseite eines Trägers 16 aufgebracht ist. Der Träger kann hier vorteilhaft elektrisch leitfähig sein bzw. aus Metall bestehen, beispielsweise ein Blech aus Edelstahl oder Aluminium sein. Auch wenn durch die gestrichelt dargestellte Bedienblende 12 der Träger 16 eben an der Rückseite der Bedienblende 12 angebracht sein kann, so ist es möglich, die PZT-Schicht 14 für das Piezo-Sensorelement 13 direkt auf einen solchen Träger 16 aufzubringen, der selbst die Bedienblende 12 bildet, so dass diese als separates Teil entfallen kann. Dazu muss der Träger 16 nur ein Stück dicker sein, um üblichen Bedienblende aus Metall wie beispielsweise von Elektro-Kochfeldern und/oder Dunstabzugshauben zu entsprechen.

Auf die PZT-Schicht 14 ist eine Elektrodenstruktur 17 aufgebracht, wie sie in Fig. 2 in der Draufsicht dargestellt ist. Die Elektrodenstruktur 17 weist mehrere Elektroden 18 auf, und zwar einmal in Fig. 2 oben und unten längs verlaufende Elektroden 18a und 18c als sogenannte Neutralelektroden. Diese sind eingangs beschrieben worden. In dem zwischen ihnen gebildeten Zwischenraum sind quer dazu weitere Elektroden 18b, 18b' und 18b" vorgesehen. Die Elektroden 18 sind als elektrisch leitfähige Beschichtungen, vorteilhaft aus Metall, auf die Rückseite der PZT-Schicht 14 aufgebracht. Sie definieren auf bekannte Art und Weise jeweils diskrete Sensorelemente, indem sie an dem von ihnen bedeckten Bereich die elektrischen Signale an der PZT-Schicht abnehmen und einer Auswertung zuführen.

Wenn vor diese diskreten Sensorelemente an der Bedienblende 12 oder einem Träger 16 ein Finger aufgelegt wird, wie es nachfolgend noch dargestellt ist, so kann die Durchbiegung erfasst werden, welche dann naturgemäß an dem dahinterliegenden Bereich der PZT-Schicht 14 bzw. Elektrode 18 am größten ist, was zu dem größten Bediensignal führt und zu der Feststellung der Steuerung, dass hier eine Bedienung erfolgt ist.

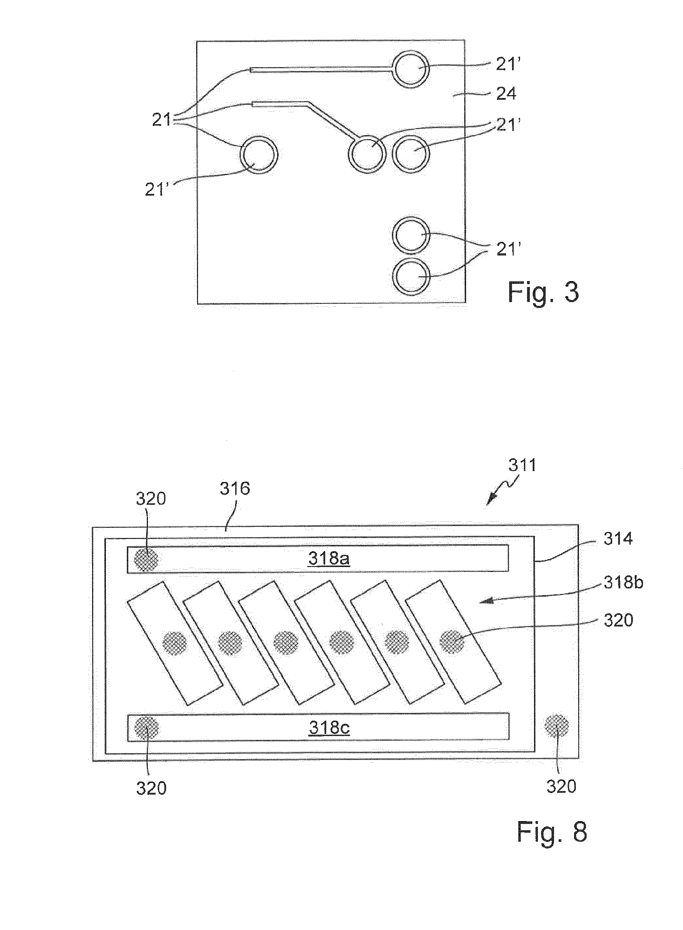

Auf die Elektroden 18 sind Kontaktelemente 20 aufgebracht, welche ebenfalls zuvor beschrieben sind. Diese können beispielsweise elektrisch leitfähige, flexible Kunststoffelemente sein. Alternativ kann es elektrisch leitfähiger Klebstoff sein. Mittels der Kontaktelemente 20 wird eine Kontaktierung an untere Kontaktfelder 21' erreicht, die gemäß Fig. 3 mit Leiterbahnen 21 verbunden sind und zu einer nicht näher dargestellten, aber leicht vorstellbaren Verschaltung geführt sind. An einer hierzu gehörenden Leitplatte 24 sind auch noch obere Leiterbahnen 22 vorgesehen, wobei die unteren Leiterbahnen 21 und die oberen Leiterbahnen 22 mittels Durchkontaktierungen 23 auf bekannte Art und Weise miteinander verbunden sind. So kann beispielsweise ein elektrischer Anschluss an in Fig. 1 dargestellte Bauteile 26 erfolgen, welche SMD-Bauteile sein können und beispielsweise eine Verschaltungselektronik wie Widerstände odgl. darstellen können, ebenso aber auch IC's.

Aus der Darstellung der Fig. 3 ist zu ersehen, dass diese Leiterplatte 24 mit den unteren Kontaktfeldern 21' und Leiterbahnen 21 direkt auf den Träger 16 entsprechend Fig. 2 aufgelegt werden kann, so dass die Kontaktfelder 21' jeweils genau an die in Fig. 2 dargestellten Kontaktelemente 20 angelegt werden.

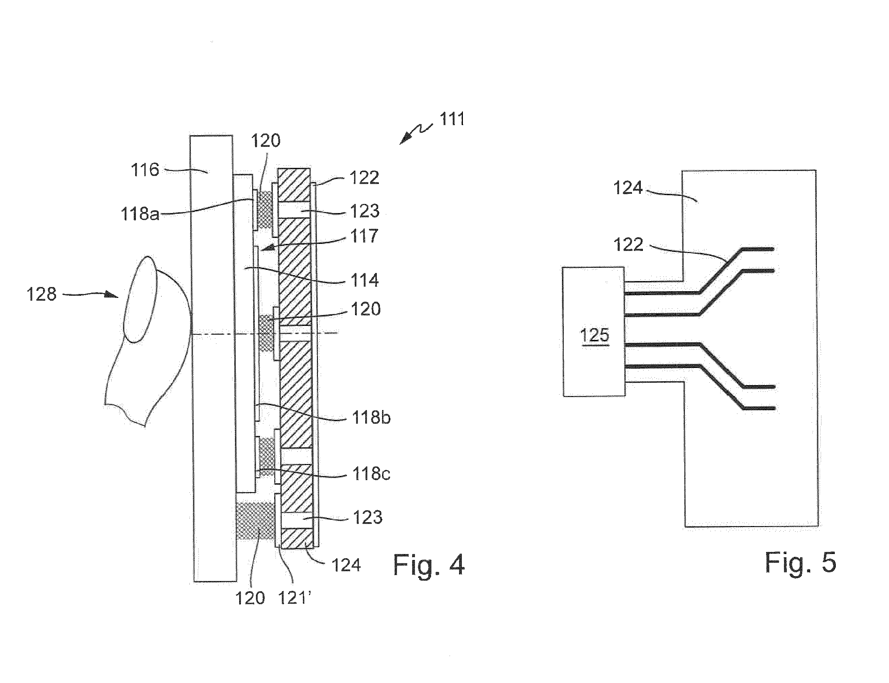

In Fig. 4 ist eine zweite Variante einer Bedieneinrichtung 111 dargestellt mit leichter Abwandlung zu den Fig. 1 bis 3. Hier ist an der Vorderseite eines Trägers 116 keine weitere Bedienblende odgl. vorgesehen, der Träger 116 bildet sie also selbst. Ein Finger 128 wird direkt an die Vorderseite des Trägers 116 angelegt. Dieser Träger 116 besteht vorteilhaft aus einem vorbeschriebenen Edelstahlblech. An seiner Rückseite ist eine PZT-Schicht 114 direkt aufgebracht, wie es eingangs beschrieben worden ist. Auf der Rückseite der PZT-Schicht 114 wiederum ist entsprechend Fig. 2 eine Elektrodenstruktur 117 mit Elektroden 118a und 118b sowie 118c aufgebracht.

Über Kontaktelemente 120 sind die Elektroden 118 an Kontaktfelder 121' elektrisch angeschlossen. Diese Kontaktfelder 121' verlaufen allerdings zusammen mit Durchkontaktierungen 123 und Leiterbahnen 122 auf einem in Fig. 5 näher in Draufsicht dargestellten Folienleiter 124. Dieser weist an einem Ende einen Anschlussstecker 125 auf, in dem die Leiterbahnen 122 zusammenlaufen zum elektrischen Anschluss nach außen.

Da hier auf dem Folienleiter 124 keine elektrischen Bauteile vorgesehen sind, wie es in Fig. 1 der Fall ist, so könnte auch vorgesehen sein, dass nur an der Unterseite, also an den Kontaktfeldern 121' zu der PZT-Schicht 114, die Leiterbahnen 121 vorgesehen sind. Dann kann auf Durchkontaktierungen 123 verzichtet werden. Es können aber auch elektrische Bauteile vorgesehen sein, zumindest auf einer Seite.

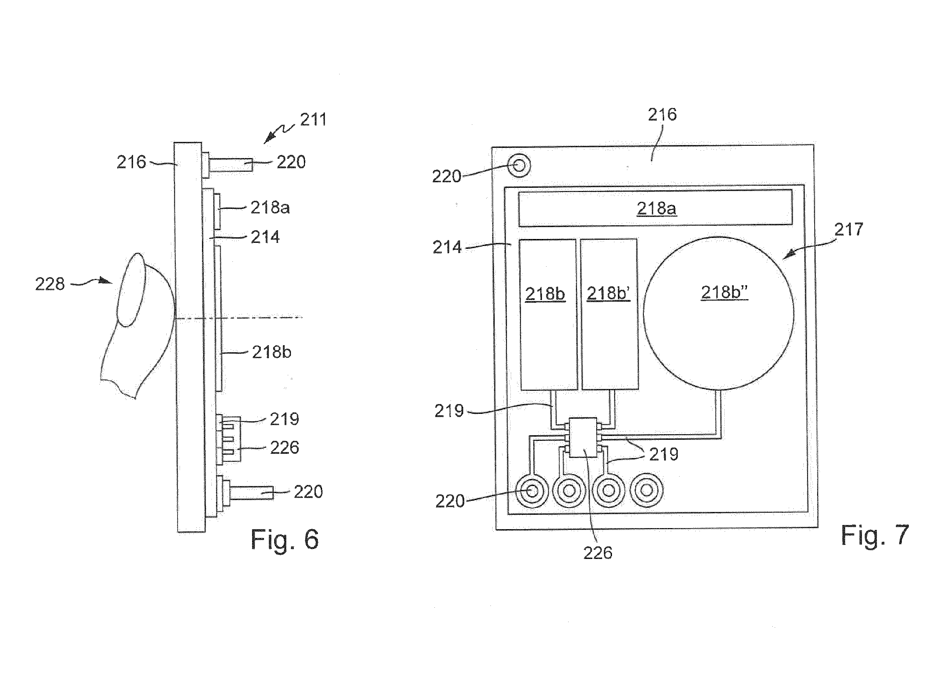

In den Fig. 6 und 7 ist eine dritte Variante einer erfindungsgemäßen Bedieneinrichtung 211 dargestellt, wobei wiederum ein Träger 216 die Bedienblende bildet und an dessen Vorderseite ein Finger 228 direkt angelegt werden kann. Der Träger 216 besteht auch hier vorteilhaft aus dünnem Blech, beispielsweise aus Edelstahl oder Aluminium.

An der Rückseite des Trägers 216 ist wiederum eine PZT-Schicht 214 als Piezo-Sensorelement aufgebracht, welches an seiner Rückseite eine aus Fig. 7 näher erkennbare Elektrodenstruktur 217 aufweist. Die einzelnen Elektroden 218a, 218b, 218b' und 218b" sind aus Fig. 7 zu erkennen. Sie sind mittels Elektroden-Leiterbahnen 219 zumindest teilweise an ein elektronisches Bauteil 226 in Form eines IC als Microcontroller angeschlossen. Weitere elektrische bzw. elektronische Bauteile können auch direkt auf das Piezo-Sensorelement bzw. die PZT Schicht 214 aufgebracht sein. Des Weiteren gehen von dem Bauteil 226 Elektroden-Leiterbahnen 219 ab zu Kontaktfeldern, an welchen die abstehenden Kontaktelemente 220 angebracht sind. Diese Kontaktelemente 220 dienen, anders als in den Fig. 1 bis 5, nicht zur elektrischen Verbindung der Elektroden 218 an das Bauteil 226, sondern an den Anschluss an eine externe Steuerung, Signalverarbeitung odgl.. Der Vorteil, Bauteile 226 bzw. IC's oder Microcontroller vorzusehen, liegt unter anderem darin, dass dann die Signalwege zwischen der PZT-Schicht 214 und einer Signalverarbeitung in den Bauteilen 226 sehr kurz sind. Dann können die fertig verarbeiteten bzw. aufbereiteten Signale wiederum gut erkennbar relativ störungsfrei an eine Steuerung odgl. eines Elektrogerätes übertragen werden. Die elektrische Kontaktierung an den Träger 16 selbst über die Kontaktelemente 20, 120 oder 220 stellt ganz allgemein die Gegenelektrode der PZT-Schicht 14 als Piezo-Sensorelement 13 dar.

Aus den Draufsichten der Fig. 2 und 7 ist auch zu ersehen, dass die PZT-Schichten 14 bzw. 214 deutlich kleiner sind als der Träger 16 bzw. 216. So können sie auf einen erheblich größeren Träger aufgebracht werden, insbesondere wenn er gemäß der Fig. 4 und 6 die Bedienblende selbst bildet und nicht auf der Rückseite einer solchen aufgebracht ist.

In Fig. 8 ist eine weitere alternative Ausgestaltung in Abwandlung der Fig. 2 dargestellt für eine Bedieneinrichtung 311. Hier ist auf die Rückseite eines Träger 316 eine rechteckige PZT-Schicht 314 aufgebracht.

Im oberen Bereich befindet sich eine längliche erste Neutralelektrode 318a und entsprechend im unteren Bereich eine zweite Neutralelektrode 318c. Dazwischen ist eine Vielzahl von Elektroden 318b angeordnet, welche die Form von länglichen rechteckigen Feldern haben entlang einer Linie. Die einzelnen Elektroden 318b sind allerdings um etwa 20° entgegen dem Uhrzeigersinn zu dieser Linie verschwenkt und überlappen sich sozusagen stark. So kann ein sogenannter Slider geschaffen werden, wie er beispielsweise aus der DE 10 2009 039 937 A1 oder der DE 10 2009 049 559 A1 bekannt ist.

Für eine eingangs beschriebene partielle Polarisierung der PZT-Schicht kann eine Maske, vorteilhaft eine Metallmaske, aufgebracht werden, welche beispielsweise die Größe des dargestellten Ausschnittes des Trägers 16 aufweist und ziemlich genau die zusammenhängende Fläche der Elektrodenstruktur 17 als Öffnung freilässt, insbesondere als zusammenhängende Öffnung. Dabei kann entsprechend Fig. 2 vorgesehen sein, dass die Maske eine Öffnung aufweist, welche auf alle Fälle so groß ist wie die einzelnen Elektroden 18a bis 18c der Elektrodenstruktur 17 bzw. nur wenig kleiner ist als die PZT-Schicht 14 selbst.

Ausgehend von Fig. 7 ist es leicht vorstellbar, wie auch ohne Bauteil 226 bzw. entsprechendes IC die einzelnen Elektroden 218 mittels Elektroden-Leiterbahnen 219 zu entfernt liegenden Kontaktfeldern mit Kontaktelementen 220 geführt sein können. Dies ist insbesondere dann von Vorteil, wenn ähnlich wie in Fig. 6 und 7 keine Leiterplatte odgl. direkt hinter der PZT-Schicht an der Bedieneinrichtung vorgesehen ist. Der erfindungsgemäße Leiterbahnträger wird dann eben erst hinter den Kontaktelementen 220 entsprechend der Fig. 6 oder 7 angeschlossen.

## Patentansprüche

1. Bedieneinrichtung für ein Elektrogerät, mit einem formveränderlichen bzw. elastischen Bedien-Feld, in welches eine Bedien-Kraft einleitbar ist zur Durchbiegung des Bedien-Felds, wobei hinter dem Bedien-Feld mindestens ein Piezo-Sensorelement angeordnet ist mit mechanischer Kopplung an das Bedien-Feld, **dadurch gekennzeichnet, dass** das Piezo-Sensorelement von einer piezoaktiven PZT-Schicht gebildet ist, welche auf einen elektrisch leitfähigen Träger aufgebracht ist und mit der Vorderseite zu dem Bedien-Feld hin weist, wobei auf der freien Rückseite des Piezo-Sensorelementes eine Elektrodenstruktur mit Elektroden aufgebracht ist.

2. Bedieneinrichtung nach Anspruch 1, **dadurch gekennzeichnet, dass** die PZT-Schicht geringe Dicke aufweist, vorzugsweise 1µm bis 10µm.

3. Bedieneinrichtung nach Anspruch 1 oder 2, **dadurch gekennzeichnet, dass** der Träger aus Metall besteht, insbesondere aus Edelstahl, wobei vorzugsweise der Träger ein Blech ist.

4. Bedieneinrichtung nach einem der vorhergehenden Ansprüche, **dadurch gekennzeichnet, dass** die Elektrodenstruktur mit Elektroden eine elektrische Kontaktierung an einen Leiterbahnträger zum elektrischen Anschluss ist, wobei vorzugsweise der Leiterbahnträger eine Folienleiterplatte ist.

5. Bedieneinrichtung nach einem der vorhergehenden Ansprüche, **dadurch gekennzeichnet, dass** die Elektrodenstruktur eine Teilfläche der PZT-Schicht bedeckt zur Bildung der Sensorelemente mit der Teilfläche der Elektrodenstruktur, der sich in Deckung mit der Teilfläche befindlichen PZT-Schicht und dem elektrisch leitfähigen Träger.

6. Bedieneinrichtung nach einem der vorhergehenden Ansprüche, **dadurch gekennzeichnet, dass** das Piezo-Sensorelement flächig ist und mit dem Bedien-Feld als Träger verbunden ist, vorzugsweise direkt an dessen Rückseite angebracht ist.

7. Bedieneinrichtung nach Anspruch 4 oder 6, **dadurch gekennzeichnet, dass** an dem Leiterbahnträger elektrische Bauteile vorgesehen sind, vorzugsweise nur an der von dem Piezo-Sensorelement abgewandten Seite.

8. Bedieneinrichtung nach einem der vorhergehenden Ansprüche, **dadurch gekennzeichnet, dass** elektrische Bauteile direkt auf das Piezo-Sensorelement bzw. die PZT Schicht, insbesondere auf Kontaktierflächen der PZT Schicht, aufgebracht bzw. mit diesen verbunden sind, wobei insbesondere die Bauteile mittels Leiterbahnen auf der Rückseite angeschlossen bzw. miteinander verbunden sind.

9. Bedieneinrichtung nach einem der vorhergehenden Ansprüche, **dadurch gekennzeichnet, dass** der Träger, vorzugsweise als dünne Platte, für das Piezo-Sensorelement an der Rückseite einer Bedienblende befestigt ist, welche an ihrer Vorderseite das Bedien-Feld bildet, wobei vorzugsweise für diese Befestigung eine Klebeschicht vorgesehen ist, wobei insbesondere die Dicke des Trägers weniger als 1 mm und vorzugsweise etwa 0,1 mm beträgt.

10. Bedieneinrichtung nach einem der Ansprüche 1 bis 8, **dadurch gekennzeichnet, dass** das Piezo-Sensorelement direkt auf die Rückseite einer Bedienblende aufgebracht ist, wobei die Bedienblende den Träger bildet und mit ihrer Vorderseite das Bedien-Feld bildet, wobei vorzugsweise die Dicke der Bedienblende weniger als 4mm beträgt, insbesondere zwischen 1 mm und 3mm liegt.

11. Bedieneinrichtung nach einem der vorhergehenden Ansprüche, **dadurch gekennzeichnet, dass** eine elektrische Kontaktierung von den Elektroden an der Rückseite des Piezo-Sensorelementes an einen Leiterbahnträger über Leitkleber oder elektrisch leitfähige, elastische Kontaktelemente erfolgt, wobei vorzugsweise die Kontaktelemente an den Elektroden oder dem Leiterbahnträger festgeklebt sind.

12. Bedieneinrichtung nach einem der vorhergehenden Ansprüche, **dadurch gekennzeichnet, dass** die PZT-Schicht als Piezo-Sensorelement großflächig aufgebracht und ausgebildet ist, wobei sie insbesondere das einzige Piezo-Sensorelement der Bedieneinrichtung bildet, wobei vorzugsweise für eine Unterteilung in einzelne Bereiche die Elektroden auf ihrer Rückseite unterschiedlich groß und/oder unterschiedlich geformt und angeordnet sind.

13. Bedieneinrichtung nach Anspruch 12, **dadurch gekennzeichnet, dass** die PZT-Schicht des Piezo-Sensorelementes rechteckige Form aufweist, und in zwei gegenüberliegenden Randbereichen längliche Neutralelektroden auf deren Rückseite aufgebracht sind, die sich vorzugsweise in einer Richtung über den wesentlichen Teil der Länge des Piezo-Sensorelementes erstrecken, zur Bestimmung des Bedienortes in Relation zum Abstand zur einen Neutralelektrode oder zur anderen Neutralelektrode, wobei insbesondere weitere Elektroden zwischen den Neutralelektroden nur entlang deren Längsrichtung nebeneinander vorgesehen sind ohne einander zu überlappen.

14. Bedieneinrichtung nach einem der vorhergehenden Ansprüche, **dadurch gekennzeichnet, dass** von den Elektroden leitfähige Abschnitte bzw. Leiterbahnen abgehen, an deren Ende ein Kontaktierfeld vorgesehen ist, wobei vorzugsweise die Kontaktierfelder sämtlicher Elektroden in einem gemeinsamen Kontaktierbereich enden.

15. Verfahren zur Herstellung einer Bedieneinrichtung nach einem der vorhergehenden Ansprüche, **dadurch gekennzeichnet, dass** zur Polarisierung der PZT-Schicht für das Piezo-Sensorelement eine Maske auf die Rückseite der PZT-Schicht aufgebracht wird, wobei dabei die Elektroden ausgespart werden zur Polarisierung und nur die Teilflächen, die als Sensorelemente wirken sollen, polarisiert werden, wobei nach der Polarisierung der PZT-Schicht die Maske entfernt wird.

16. Verfahren nach Anspruch 15, **dadurch gekennzeichnet, dass** Flächenanteile, die mit Leiterbahnen oder Bauteilen versehen werden, bedeckt werden und nicht polarisiert werden.
